# EUROPEAN PATENT APPLICATION

(11) **EP 3 522 206 A1**
(43) Date of publication of application: **07.08.2019**
(21) Application number: 19153477.5
(22) Date of filing: 24.01.2019
(51) Int. Cl.: H01L 21/60, H01L 23/485

(54) **SEMICONDUCTOR DEVICE AND MANUFACTURING METHOD THEREOF**

(30) Priority: 30.01.2018 JP 2018013192
(71) Applicant: Renesas Electronics Corporation, 135-0061 Tokyo (JP)
(72) Inventor: TSUCHIYA, Hideaki, Tokyo 135-0061 (JP)
(74) Representative: Betten & Resch

(57) **Abstract**

A semiconductor device includes a pad electrode formed over a semiconductor substrate, a conductor pillar formed on the pad electrode, a cap film formed on the conductor pillar and made of a nickel film, a terminal formed in a wiring board, a metal film formed on the terminal and made of a nickel film containing phosphorus, a solder layer interposed between the cap film and the metal film and containing tin as a main component, and an alloy layer interposed between the solder layer and the metal film and containing tin and copper.

## Description

### CROSS-REFERENCE TO RELATED APPLICATION

The present application claims priority from Japanese Patent Application No. 2018-013192 filed on January 30, 2018, the content of which is hereby incorporated by reference into this application.

### TECHNICAL FIELD OF THE INVENTION

The present invention relates to a semiconductor device and a manufacturing method thereof, and relates to, for example, a technique effectively applicable to a semiconductor device using a wiring board with barrier metal specifications and a manufacturing method thereof.

### BACKGROUND OF THE INVENTION

Japanese Patent Application Laid-Open Publication No. 2013-211511 (Patent Document 1) discloses a structure in which the electrode pad PAD of the semiconductor chip SC and the connection terminal TER of the wiring board INT are connected by the bump electrode composed of the Cu pillar PIL and the solder layer SOL. Further, Patent Document 1 discloses that the Ni layer NIL is interposed between the Cu pillar PIL and the solder layer SOL in order to prevent the diffusion of Cu from the Cu pillar PIL to the Sn-based solder layer SOL due to electromigration.

Japanese Patent Application Laid-Open Publication No. 2014-053608 (Patent Document 2) discloses a wiring board with barrier metal specifications using the plating method. Namely, the surface of the circuit pattern ("connection terminal" mentioned above) of the wiring board is covered with a stacked film of nickel layer/gold layer or a stacked film of nickel layer/palladium layer/gold layer. Also, as the plating method, surface treatment of electroless gold plating series such as ENIG (Electroless Nickel Immersion Gold) or ENEPIG (Electroless Nickel Electroless Palladium Immersion Gold) is disclosed.

### SUMMARY OF THE INVENTION

The inventor of the present invention has been studying a semiconductor device in which the semiconductor chip of the Patent Document 1 is mounted on the wiring board of the Patent Document 2. According to the study by the inventor of the present invention, it has been found that the electromigration lifetime of the bump electrode that connects the electrode pad of the semiconductor chip and the connection terminal of the wiring board is shortened in the semiconductor device like this. In other words, it has been found that the electromigration lifetime is shortened in the connection structure between the semiconductor chip and the wiring board and the reliability of the semiconductor device cannot be ensured.

Namely, in the semiconductor device using a wiring substrate with barrier metal specifications, improvement in reliability is required.

Other problems and novel features of the present invention will be apparent from the description of the present specification and the accompanying drawings.

A semiconductor device according to an embodiment comprises: a pad electrode formed over a semiconductor substrate; a conductor pillar formed on the pad electrode; a cap film formed on the conductor pillar and made of a nickel film; a terminal formed in a wiring board; a metal film formed on the terminal and made of a nickel film containing phosphorus; a solder layer interposed between the cap film and the metal film and containing tin as a main component; and an alloy layer interposed between the solder layer and the metal film and containing tin and copper.

According to the embodiment, it is possible to improve the reliability of the semiconductor device.

### BRIEF DESCRIPTIONS OF THE DRAWINGS

FIG. 1 is a top view of a semiconductor device according to a present embodiment;
FIG. 2 is a bottom view of the semiconductor device according to the present embodiment;
FIG. 3 is a partial cross-sectional view of the semiconductor device according to the present embodiment;
FIG. 4 is a process flow chart showing a manufacturing process of the semiconductor device according to the present embodiment;
FIG. 5 is a cross-sectional view of a principal part in the manufacturing process of the semiconductor device according to the present embodiment;
FIG. 6 is a cross-sectional view of a principal part showing a configuration of a portion A in FIG. 5;
FIG. 7 is a cross-sectional view of a principal part showing a configuration of a semiconductor chip according to the present embodiment;
FIG. 8 is a cross-sectional view of a principal part in a manufacturing process of the semiconductor chip according to the present embodiment;
FIG. 9 is a cross-sectional view of a principal part in the manufacturing process of the semiconductor chip continued from FIG. 8;
FIG. 10 is a cross-sectional view of a principal part in the manufacturing process of the semiconductor chip continued from FIG. 9;
FIG. 11 is a cross-sectional view of a principal part in the manufacturing process of the semiconductor chip continued from FIG. 10;
FIG. 12 is a cross-sectional view of a principal part in the manufacturing process of the semiconductor device according to the present embodiment;
FIG. 13 is a cross-sectional view of a principal part showing a configuration of a portion B in FIG. 12;
FIG. 14 is a cross-sectional view of a principal part in the manufacturing process of the semiconductor device according to the present embodiment;
FIG. 15 is a cross-sectional view of a principal part showing a configuration of a portion C in FIG. 14;
FIG. 16 is a cross-sectional view of a principal part in the manufacturing process of the semiconductor device according to the present embodiment;
FIG. 17 is a cross-sectional view of a principal part in the manufacturing process of the semiconductor device according to the present embodiment;
FIG. 18 is a diagram showing an effect of the semiconductor device according to the present embodiment;
FIG. 19 is a cross-sectional view of a principal part of a semiconductor device according to a comparative example;
FIG. 20 is a cross-sectional view showing a configuration of a portion D in FIG. 19;
FIG. 21 is a cross-sectional view of a principal part in a manufacturing process of a semiconductor device according to a first modification;
FIG. 22 is a cross-sectional view of a principal part in the manufacturing process of the semiconductor device according to the first modification;
FIG. 23 is a cross-sectional view of a principal part in a manufacturing process of a semiconductor device according to a second modification;
FIG. 24 is a cross-sectional view of a principal part in the manufacturing process of the semiconductor device according to the second modification; and
FIG. 25 is a cross-sectional view of a principal part in the manufacturing process of the semiconductor device according to the second modification.

### DESCRIPTIONS OF THE PREFERRED EMBODIMENTS

In the embodiment described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof.

Also, in the embodiment described below, when referring to the number of elements (including number of pieces, values, amount, range, and the like), the number of the elements is not limited to a specific number unless otherwise stated or except the case where the number is apparently limited to a specific number in principle, and the number larger or smaller than the specified number is also applicable.

Further, in the embodiment described below, the constituent elements (including element steps) are not always indispensable unless otherwise stated or except the case where the constituent elements are apparently indispensable in principle.

Similarly, in the embodiment described below, when the shape of the constituent elements, positional relation thereof, and the like are mentioned, the substantially approximate and similar shapes and the like are included therein unless otherwise stated or except the case where it is conceivable that they are apparently excluded in principle. The same goes for the numerical value and the range described above.

In addition, the same members are denoted by the same reference characters in principle throughout the drawings for describing the embodiment, and the repetitive description thereof will be omitted. Note that hatching is sometimes applied even in a plan view so as to make the drawings easy to see.

### (Embodiment)

### <Structure of Semiconductor Device>

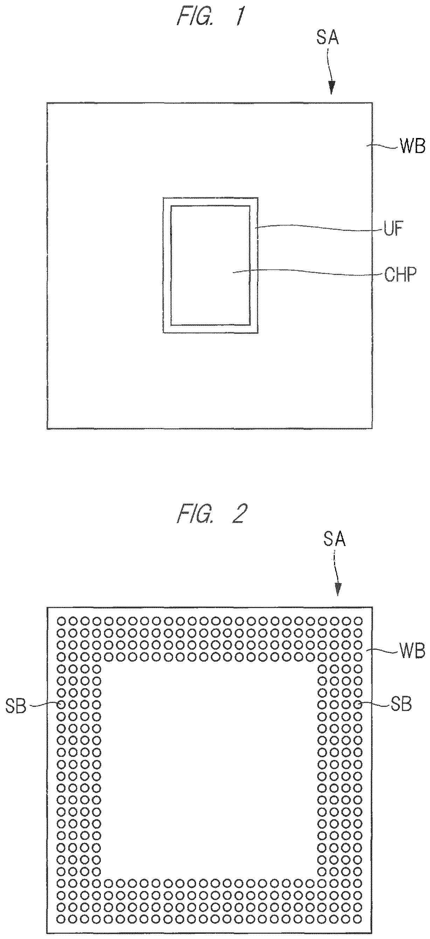

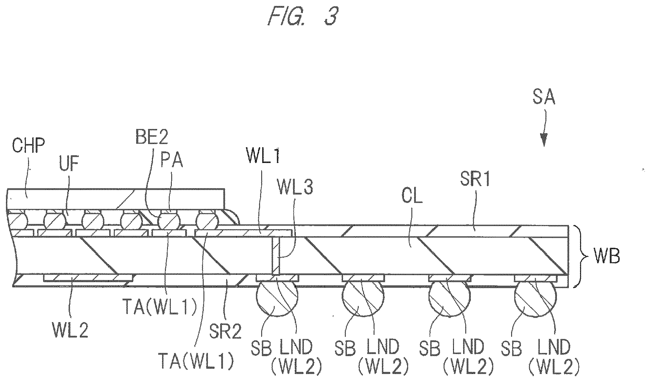

FIG. 1 is a top view of a semiconductor device according to the present embodiment. FIG. 2 is a bottom view of the semiconductor device according to the present embodiment. FIG. 3 is a partial cross-sectional view of the semiconductor device according to the present embodiment.

As shown in FIG. 1, a semiconductor device SA according to the present embodiment includes a square wiring board WB, and a rectangular semiconductor chip CHP is mounted on a center of a main surface of the wiring board WB via a sealing material (underfill) UF. As shown in FIG. 1, a size of the semiconductor chip CHP is smaller than that of the wiring board WB. Note that the wiring board WB may have a rectangular shape and the semiconductor chip CHP may have a square shape.

Subsequently, as shown in FIG. 2, a plurality of solder balls SB are arranged in an array on a back surface of the wiring board WB. FIG. 2 shows an example in which the solder balls SB are arranged in four rows along an outer peripheral portion (outer edge portion) of the wiring board WB. These solder balls SB function as external connection terminals for connecting the semiconductor device SA to external equipment. Namely, the solder balls SB are used when the semiconductor device SA is mounted on a circuit board typified by, for example, a mother board. The solder balls SB may also be arranged in a matrix pattern over the entire back surface of the wiring board WB.

FIG. 3 is a partial cross-sectional view of the semiconductor device SA according to the present embodiment. Although the wiring board WB has a multilayer wiring structure, FIG. 3 shows only each one layer for a core layer CL, a wiring WL1 on the main surface side of the core layer CL, and a wiring WL2 on the back surface side. The wirings WL1 and WL2 are made of a copper (Cu) film. An upper surface and a side surface of the wiring WL1 formed on the main surface side of the core layer CL are covered with a solder resist film SR1. A terminal TA formed in a part of the wiring WL1 is exposed from the solder resist film SR1 at an opening provided in the solder resist film SR1, and is connected to a bump electrode BE2 in the opening. A lower surface and a side surface of the wiring WL2 formed on the back surface side of the core layer CL are covered with a solder resist film SR2. A land LND formed in a part of the wiring WL2 is exposed from the solder resist film SR2 at an opening provided in the solder resist film SR2, and the solder ball SB is connected to the land LND in the opening. The wiring WL1 on the main surface is connected to the wiring WL2 on the back surface through a wiring WL3 provided in a via that penetrates the core layer CL. The solder resist films SR1 and SR2 are insulating films made of insulating resin, and the core layer CL is made of an insulating resin substrate such as glass epoxy resin.

The semiconductor chip CHP is mounted on the wiring board WB, and the bump electrode BE2 connected to a pad electrode PA formed on a main surface of the semiconductor chip CHP is connected to the terminal TA exposed from the solder resist film SR1. Further, the sealing material (underfill) UF is injected to fill a gap between the semiconductor chip CHP and the wiring board WB. Namely, the semiconductor chip CHP is mounted on the main surface of the wiring board WB via the bump electrode BE2 such that the main surface of the semiconductor chip CHP faces the main surface of the wiring board WB. Further, the space between the main surface of the semiconductor chip CHP and the main surface of the wiring board WB is completely filled with the sealing material UF and the space between the plurality of bump electrodes BE2 is also completely filled with the sealing material UF. In other words, the side wall (side surface, front surface) of the bump electrode BE2 is in contact with the sealing material UF in the entire circumference. The sealing material UF is provided for, for example, weakening the stress applied to the bonding portion between the bump electrode BE2 and the terminal TA, and is made of an insulating resin film such as epoxy resin.

### <Manufacturing Method of Semiconductor Device>

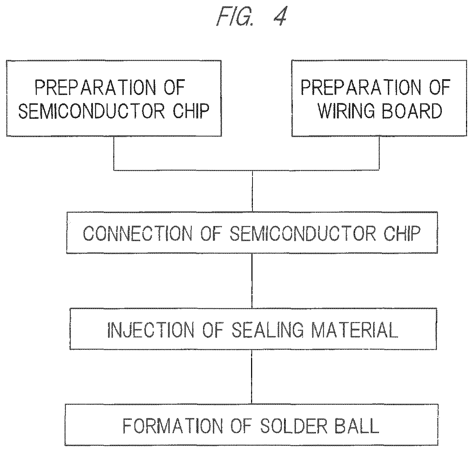

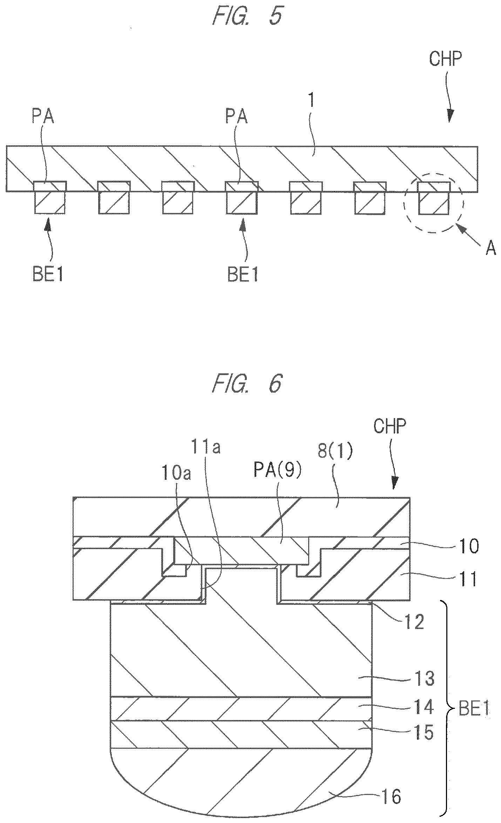

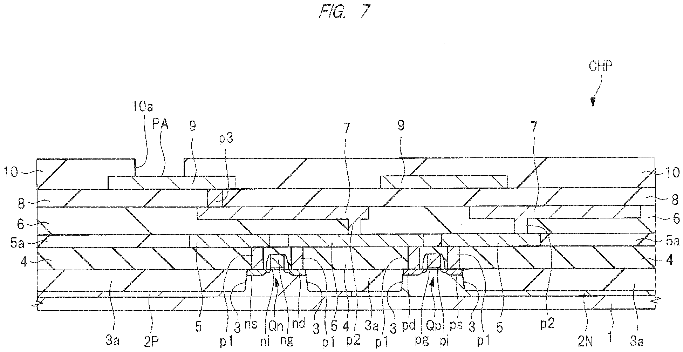

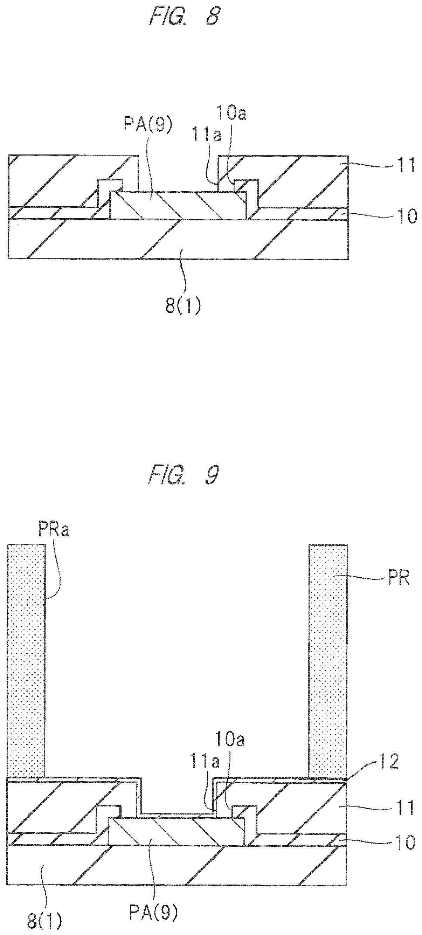

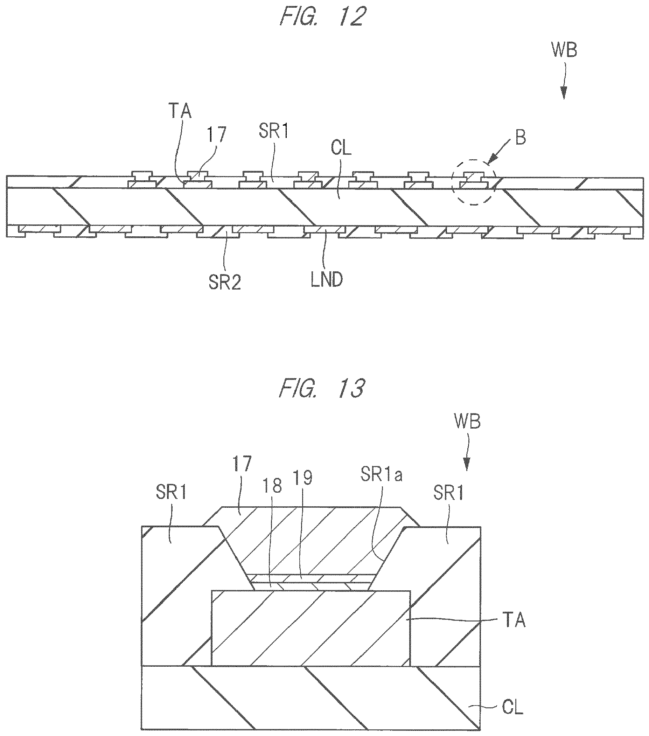

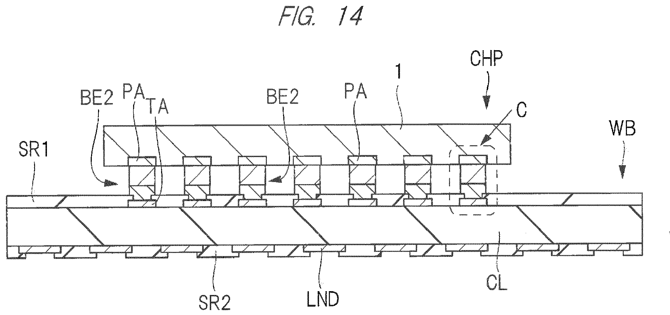

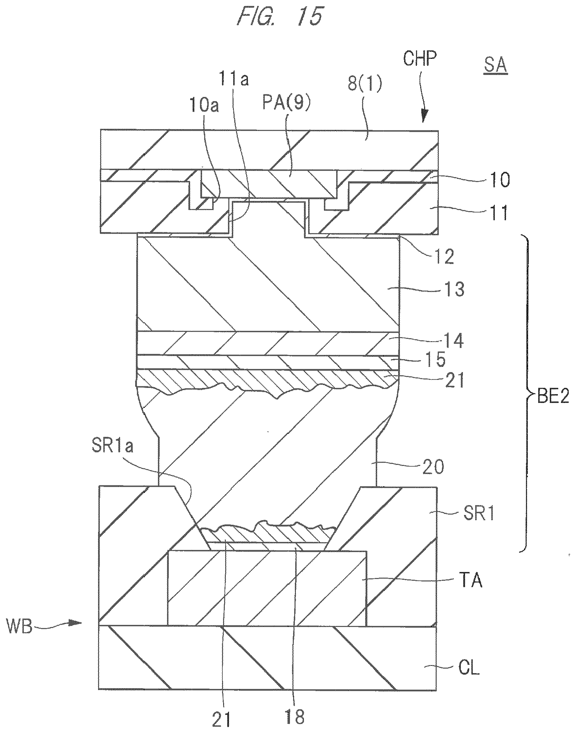

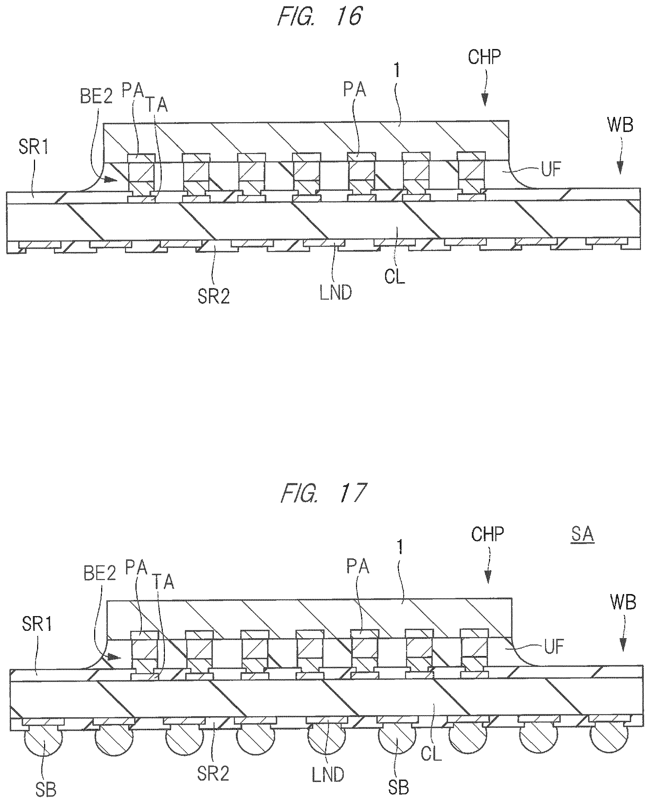

Next, a manufacturing method of a semiconductor device according to the present embodiment will be described with reference to FIGs. 4 to 17. FIG. 4 is a process flow chart showing a manufacturing process of the semiconductor device according to the present embodiment. FIG. 5 is a cross-sectional view of a principal part in the manufacturing process of the semiconductor device according to the present embodiment, and shows a schematic cross-sectional view of the semiconductor chip. FIG. 6 is a cross-sectional view of a principal part showing a configuration of a portion A in FIG. 5, and FIG. 7 is a cross-sectional view of a principal part showing a configuration of the semiconductor chip according to the present embodiment. Further, FIGs. 8 to 11 are cross-sectional views of a principal part in the manufacturing process of the semiconductor chip. FIG. 12 is a cross-sectional view of a principal part in the manufacturing process of the semiconductor device according to the present embodiment, and FIG. 13 is a cross-sectional view of a principal part showing a configuration of a portion B in FIG. 12. FIG. 14 is a cross-sectional view of a principal part in the manufacturing process of the semiconductor device according to the present embodiment, and FIG. 15 is a cross-sectional view of a principal part showing a configuration of a portion C in FIG. 14. FIG. 16 and FIG. 17 are cross-sectional views of a principal part in the manufacturing process of the semiconductor device according to the present embodiment.

As shown in FIG. 4, the manufacturing method of the semiconductor device according to the present embodiment includes a semiconductor chip preparing step, a wiring board preparing step, a semiconductor chip connecting step, a sealing material injecting step, and a solder ball forming step. Further, after the semiconductor chip preparing step and the wiring board preparing step are carried out, the semiconductor chip connecting step, the sealing material injecting step, and the solder ball forming step are carried out in sequence.

First, the semiconductor chip preparing step in FIG. 4 is carried out. As shown in FIG. 5, the semiconductor chip CHP includes the plurality of pad electrodes PA and the bump electrode BE1 formed on each of the pad electrodes PA. As shown in FIG. 6, the bump electrode BE1 has a configuration in which a seed layer 12, a conductor pillar 13, a cap film 14, a metal film 15, and a solder layer 16 are stacked in sequence. In FIG. 6, the semiconductor chip CHP is shown such that the main surface faces downward.

As shown in FIG. 6, the pad electrode PA is formed over a semiconductor substrate 1. A surface protective film (protective film, insulating film) 10 made of an inorganic insulating film is formed over the semiconductor substrate 1 so as to cover the pad electrode PA. The surface protective film 10 is composed of a stacked structure of, for example, a silicon oxide film and a silicon nitride film, and mechanically protects semiconductor elements and wirings described later. In addition, a protective film (organic insulating film) 11 made of, for example, a polyimide resin film is formed on the surface protective film 10. The surface protective film 10 has an opening 10a, and the pad electrode PA is exposed from the opening 10a. In addition, the protective film 11 has an opening 11a whose diameter is smaller than that of the opening 10a, and the pad electrode PA is exposed from the opening 11a. Further, the bump electrode BE1 is connected to the pad electrode PA through the opening 11a.

As shown in FIG. 6, since the protective film 11 is interposed between the bump electrode BE1 and the semiconductor chip CHP, it is possible to suppress the stress applied to the bump electrode BE1 from propagating to the semiconductor chip CHP, so that the occurrence of cracks in the semiconductor chip CHP can be prevented.

As shown in FIG. 7, the semiconductor chip CHP includes semiconductor elements such as an n-channel MIS transistor (Qn) and a p-channel MIS transistor (Qp) formed on the semiconductor substrate 1 and a first-layer Cu wiring 5, a second-layer Cu wiring 7, and a third-layer Al wiring 9 formed over the semiconductor substrate 1.

As shown in FIG. 7, a p-type well 2P, an n-type well 2N, and an element isolation trench 3 are formed in the semiconductor substrate 1 made of, for example, p-type single crystal silicon, and an element isolation film 3a made of, for example, a silicon oxide film is buried in the element isolation trench 3.

The n-channel MIS transistor (Qn) is formed in the p-type well 2P. The n-channel MIS transistor (Qn) is formed in an active region defined by the element isolation trench 3, and includes a source region ns and a drain region nd formed in the p-type well 2P, and a gate electrode ng formed on the p-type well 2P via a gate insulating film ni. Also, the p-channel MIS transistor (Qp) is formed in the n-type well 2N, and the p-channel MIS transistor (Qp) includes a source region ps and a drain region pd, and a gate electrode pg formed on the n-type well 2N via a gate insulating film pi.

Wirings that are made of metal films to connect these semiconductor elements are formed above the n-channel MIS transistor (Qn) and the p-channel MIS transistor (Qp) . The wirings to connect the semiconductor elements generally have a multilayer wiring structure composed of three to ten layers, although FIG. 7 shows, as an example of the multilayer wiring, wiring layers in two layers (first-layer Cu wiring 5, second-layer Cu wiring 7) made of metal films containing copper alloy as a main component and a wiring layer in one layer (third-layer Al wiring 9) made of a metal film containing Al alloy as a main component. The wiring layer is used when collectively showing a plurality of wirings formed in respective wiring layers. With respect to the film thickness of the wiring layers, the wiring layer in the second layer is thicker than the wiring layer in the first layer, and the wiring layer in the third layer is thicker than the wiring layer in the second layer.

Interlayer insulating films 4, 6, and 8 each made of a silicon oxide film or the like and plugs p1, p2, and p3 for electrically connecting the wirings in the three layers are formed between the n-channel MIS transistor (Qn) and the p-channel MIS transistor (Qp) and the first-layer Cu wiring 5, between the first-layer Cu wiring 5 and the second-layer Cu wiring 7, and between the second-layer Cu wiring 7 and the third-layer Al wiring 9, respectively.

The interlayer insulating film 4 is formed over the semiconductor substrate 1 so as to cover the semiconductor elements, and the first-layer Cu wiring 5 is formed in an insulating film 5a on the interlayer insulating film 4. The first-layer Cu wiring 5 is electrically connected to the source region ns, the drain region nd, and the gate electrode ng of the n-channel MIS transistor (Qn), which is a semiconductor element, through the plug p1 formed in the interlayer insulating film 4. Also, the first-layer Cu wiring 5 is electrically connected to the source region ps, the drain region pd, and the gate electrode pg of the p-channel MIS transistor (Qp), which is a semiconductor element, through the plug p1 formed in the interlayer insulating film 4. The connection between the gate electrodes ng and pg and the first-layer Cu wiring 5 is not illustrated. The plugs p1, p2, and p3 are made of metal films, for example, W (tungsten) films. The first-layer Cu wiring 5 is formed by the damascene method in a wiring trench of the insulating film 5a, and the first-layer Cu wiring 5 is composed of a stacked structure including a barrier conductor film and a conductor film containing copper as a main component in an upper layer thereof. The barrier conductor film is made of tantalum (Ta), titanium (Ti), ruthenium (Ru), tungsten (W), manganese (Mn), nitride thereof, nitrosilicide thereof, or stacked film thereof. The conductor film containing copper as a main component is formed of copper (Cu) or copper alloy (alloy of copper (Cu) and aluminum (Al), magnesium (Mg), titanium (Ti), manganese (Mn), iron (Fe), zinc (Zn), zirconium (Zr), niobium (Nb), molybdenum (Mo), ruthenium (Ru), palladium (Pd), silver (Ag), gold (Au), In (indium), lanthanoid metal, actinoid metal, or the like).

The second-layer Cu wiring 7 is electrically connected to the first-layer Cu wiring 5 through, for example, the plug p2 formed in the interlayer insulating film 6. The third-layer Al wiring 9 is electrically connected to the second-layer Cu wiring 7 through, for example, the plug p3 formed in the interlayer insulating film 8. The plug p3 is made of a metal film, for example, a W (tungsten) film.

The second-layer Cu wiring 7 is formed integrally with the plug p2 in the interlayer insulating film 6, and the second-layer Cu wiring 7 and the plug p2 are composed of a stacked structure including the barrier conductor film and the conductor film containing copper as a main component in an upper layer thereof. Also, the barrier conductor film and the conductor film containing copper as a main component are made of the same material as the first-layer Cu wiring 5.

In addition, a barrier insulating film for preventing the diffusion of copper to the interlayer insulating film 6 or 8 is preferably provided each between the first-layer Cu wiring 5 and the interlayer insulating film 6 and between the second-layer Cu wiring 7 and the interlayer insulating film 8, and an SiCN film or a stacked film of an SiCN film and an SiCO film can be used as the barrier insulating film.

In addition, the third-layer Al wiring 9 is made of an aluminum alloy film (for example, Al film to which Si and Cu is added) . Alternatively, the third-layer A1 wiring 9 may be a Cu wiring.

Further, the interlayer insulating film 4 is made of a silicon oxide film (SiC₂) . Alternatively, the interlayer insulating film 4 may be of course made of a single film or a stacked film of a silicon oxide film containing carbon (SiOC film), a silicon oxide film containing nitrogen and carbon (SiOCN film), and a silicon oxide film containing fluorine (SiOF film).

The surface protective film 10 described above is formed on the third-layer Al wiring 9 which is the uppermost wiring layer of the multilayer wiring. Also, the third-layer Al wiring 9 which is the uppermost wiring layer exposed at the bottom of the opening (pad opening) 10a formed in the surface protective film 10 constitutes the pad electrode (pad, electrode pad) PA.

Next, a manufacturing method of the bump electrode BE1 will be described with reference to FIGs. 8 to 11.

As shown in FIG. 8, the protective film 11 having the opening 11a that exposes a part of the pad electrode PA is formed over the semiconductor substrate 1.

Next, as shown in FIG. 9, the seed layer 12 made of a copper film is formed on the protective film 11. The seed layer 12 is formed by, for example, the sputtering method, and has a film thickness of 100 to 500 nm. The seed layer 12 is in contact with the pad electrode PA in the opening 11a. Note that it is preferable to interpose a barrier layer between the pad electrode PA and the seed layer 12 in order to prevent reaction between the pad electrode PA and the seed layer 12. For example, the barrier layer is formed to have a stacked structure of a titanium (Ti) film and a titanium nitride (TiN) film, and film thicknesses thereof are 10 nm and 50 nm, respectively. Next, a resist layer PR is formed on the seed layer 12. The resist layer PR has an opening PRa at a region where the bump electrode BE1 is formed.

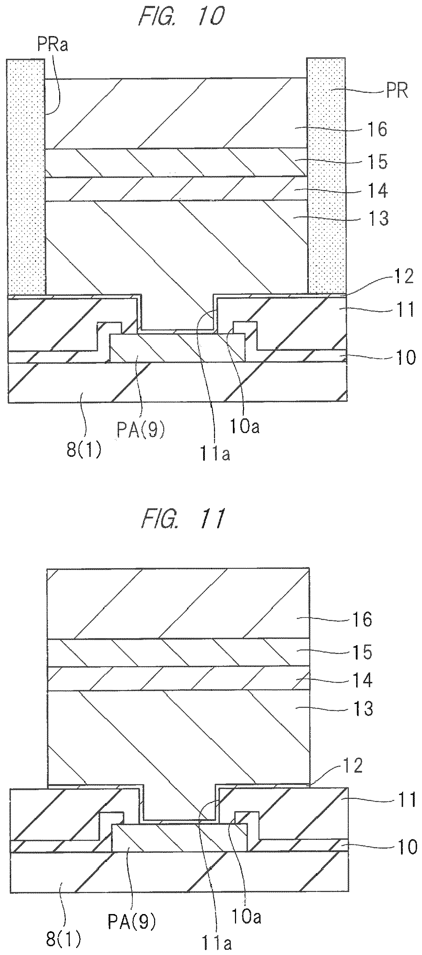

Next, as shown in FIG. 10, the conductor pillar 13, the cap film 14, the metal film 15, and the solder layer 16 are sequentially formed in the opening PRa by the electroplating method. The conductor pillar 13 is made of, for example, a copper (Cu) film, and has a film thickness of about 50 µm. The cap film 14 is made of, for example, a nickel (Ni) film, and has a film thickness of 0.1 to 10 µm. The metal film 15 is made of a copper (Cu) film and has a film thickness of about 3 to 5 µm. As the solder layer 16, alloys containing tin (Sn) as a main component such as Sn-Ag-Cu, Sn-Cu, Sn-Zn, Sn-Ag-Bi, and Sn-Ag-In can be used, and a film thickness thereof is, for example, 5 to 20 µm.

Next, as shown in FIG. 11, the resist layer PR is removed, and the seed layer 12 in the region exposed from the conductor pillar 13, the cap film 14, the metal film 15, and the solder layer 16 is removed. Next, heat treatment is applied to the solder layer 16 at a temperature higher than the melting point thereof such that the solder layer 16 has a substantially hemispherical shape as shown in FIG. 6. In this manner, as shown in FIG. 6, the bump electrode BE1 composed of the seed layer 12, the conductor pillar 13, the cap film 14, the metal film 15, and the solder layer 16 is formed on the pad electrode PA.

Next, the wiring board preparing step in FIG. 4 is carried out. As shown in FIG. 12, the wiring board WB having the plurality of terminals TA on the main surface side and the plurality of lands LND on the back surface side is prepared. As shown in FIG. 13, the terminal TA made of a copper (Cu) film is covered with the solder resist film SR1, but a part of the upper surface of the terminal TA is exposed from an opening SR1a. In the wiring board WB with barrier metal specifications according to the present embodiment, the terminal TA is covered with a metal film 18 and a barrier layer 19 in sequence in the opening SR1a, and a solder layer 17 is formed on the barrier layer 19. Herein, the metal film 18 is made of an Ni film formed by the electroless plating method. The Ni film formed by the electroless plating method contains phosphorus (P) as a reducing agent and is denoted as Ni-P. The metal film 18 is a nickel (Ni) film containing phosphorus (P). The barrier layer 19 is configured as a stacked film of a palladium (Pd) film formed by the electroless plating method and a gold (Au) film formed by the immersion plating method or as a single film of a gold (Au) film formed by the immersion plating method. In addition, the solder layer 17 is the same as the solder layer 16 described above. Though not shown, the metal film 18 and the barrier layer 19 described above are formed also on the land LND of the wiring board WB.

Next, the semiconductor chip connecting step in FIG. 4 is carried out. As shown in FIG. 14, the solder layer 16 shown in FIG. 6 is brought into contact with the solder layer 17 shown in FIG. 13, and a reflow (heat treatment) process is performed at a temperature higher than the melting point of the solder layers 16 and 17 (for example, 220 to 260°C) . Then, the solder layers 16 and 17 are melted and a solder layer 20 in which both are integrated with each other is formed, thereby electrically connecting the pad electrode PA and the terminal TA. Specifically, as shown in FIG. 15, the solder layer 20 is formed by integrating the solder layer 16 shown in FIG. 6 and the solder layer 17 shown in FIG. 13. In addition, copper (Cu) contained in the metal film 15 is diffused into the solder layer 20 in the reflow process, so that an alloy layer 21 made of copper (Cu) and tin (Sn) is formed at each of the interface between the metal film 15 and the solder layer 20 and the interface between the metal film 18 and the solder layer 20. Note that the barrier layer 19 shown in FIG. 13 is diffused into the solder layer 20 in the reflow process, and is thus not shown in FIG. 15.

Note that the conductor layer having the stacked structure that connects the pad electrode PA and the terminal TA as shown in FIG. 15 is referred to as the bump electrode BE2. Namely, the bump electrode BE2 is composed of the seed layer 12, the conductor pillar 13, the cap film 14, the metal film 15, the alloy layer 21, the solder layer 20, the alloy layer 21, and the metal film 18 in sequence. Herein, the conductor pillar 13 is provided for ensuring the height of the bump electrode BE2, and the film thickness thereof is preferably set to be larger than those of the other conductor films constituting the bump electrode BE2. In addition, the cap film 14 has an effect of preventing the solder layer 20 from wicking up the side wall of the conductor pillar 13 in the reflow process.

Next, the sealing material injecting step in FIG. 4 is carried out. As shown in FIG. 16, the sealing material UF made of an insulating resin film is injected into the gap between the semiconductor chip CHP and the wiring board WB, and then the sealing material UF is cured by the heat treatment.

Next, the solder ball forming step in FIG. 4 is carried out. As shown in FIG. 17, the solder ball SB is bonded to the land LND of the wiring board WB. Thus, the semiconductor device SA of the present embodiment is completed.

In the present embodiment, it is vital that the alloy layer 21 made of copper (Cu) and tin (Sn) is formed at the interface between the metal film 18 and the solder layer 20 as shown in FIG. 15. By providing the alloy layer 21 at the interface between the metal film 18 and the solder layer 20 in the reflow process, the diffusion of nickel (Ni) from the metal film 18 to the solder layer 20 during the operation of the semiconductor device can be prevented. Though described later, it is possible to prevent the formation of a brittle layer 22 in the metal film 18, and the disconnection that occurs between the terminal TA and the solder layer 20 can be prevented.

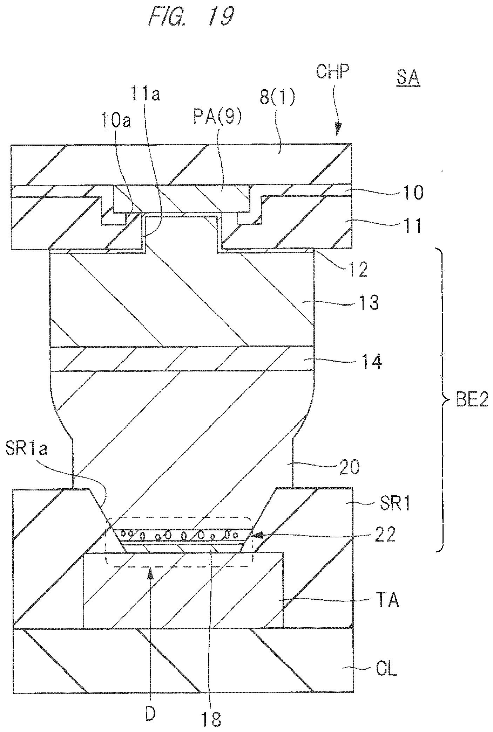

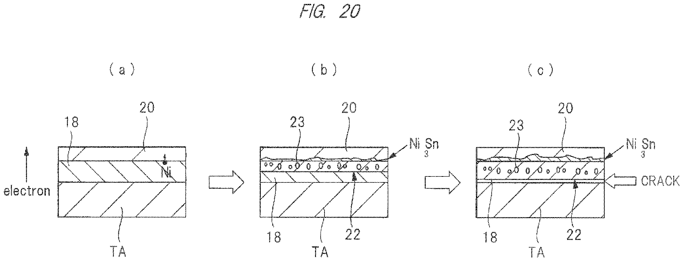

This point will be described using a comparative example. FIG. 19 is a cross-sectional view of a principal part of a semiconductor device according to a comparative example, and FIG. 20 is a cross-sectional view showing a configuration of a portion D in FIG. 19. As shown in FIG. 19, the metal film 15 is not formed in the semiconductor device according to the comparative example unlike the present embodiment described above.

When the operation acceleration test is performed to the semiconductor device according to the comparative example, it has been found that the brittle layer 22 is formed at the interface between the terminal TA and the solder layer 20 as shown in FIG. 19 and cracks occur in the brittle layer 22, so that the terminal TA and the pad electrode PA are disconnected. In the operation acceleration test, it has been found that current direction dependency exists in the formation of the brittle layer 22 and the brittle layer 22 is formed only when the current flows from the pad electrode PA to the terminal TA.

FIG. 20 shows the three states (a) to (c) with different operation times in the operation acceleration test. The operation time becomes longer in the order of states (a), (b), and (c). It has been found that the brittle layer 22 is formed in the metal film 18 and cracks occur in the metal film 18 as the operation time elapses. When current flows from the pad electrode PA to the terminal TA, electrons flow from the terminal TA to the pad electrode PA as shown in FIG. 20. At this time, nickel (Ni) in the metal film 18 made of electroless Ni-P is diffused into the solder layer 20 by the electromigration. In the region from which nickel (Ni) is left, the brittle layer 22 made of an Ni₃P layer containing a lot of streaky voids 23 is formed, and cracks occur at the interface between the brittle layer 22 and the terminal TA. Note that, in the case where current flows from the terminal TA to the pad electrode PA, the brittle layer 22 described above is not formed in the cap film 14. Since the cap film 14 is a film formed by electroplating and does not contain P, it can be said that the brittle layer made of an Ni₃P layer is not formed even if Ni is diffused into the solder layer 20 under the stress of electromigration.

In contrast to the comparative example, as shown in FIG. 15, the alloy layer 21 is formed at the interface between the metal film 18 and the solder layer 20 in the reflow process in the manufacturing process of the semiconductor device SA in the present embodiment. Therefore, it is possible to prevent the diffusion of nickel (Ni) from the metal film 18 to the solder layer 20 during the operation of the semiconductor device SA. Namely, it is possible to prevent the formation of the brittle layer 22 shown in FIG. 19.

Therefore, it is preferable that the alloy layer 21 is formed so as to have a desired film thickness or more over the entire region of the opening SR1a at the interface between the metal film 18 and the solder layer 20. If the alloy layer 21 having a desired film thickness is formed at the interface between the metal film 18 and the solder layer 20 after the reflow process, it is not always necessary that the metal film 15 remains. However, in order to form the alloy layer 21 having a desired film thickness at the interface between the metal film 18 and the solder layer 20, it is preferable that the metal film 15 remains between the cap film 14 and the alloy layer 21 after the reflow process as shown in FIG. 15. This is because it is preferable that the film thickness of the alloy layer 21 formed at the interface between the metal film 18 and the solder layer 20 is controlled by the reflow temperature and reflow time. Namely, it is vital that the metal film 15 has a film thickness enough to remain after the reflow. For this purpose, the film thickness of the metal film 15 in FIG. 11 is preferably 3 µm or more. Also, when the film thickness of the metal film 15 is too large, there is a possibility that the solder layer 20 wicks up the side wall of the remaining film of the metal film 15 during the reflow, so that it becomes difficult to control the height of the bump electrode BE2. In consideration to this point, it is preferable that the film thickness of the metal film 15 is 5 µm or less.

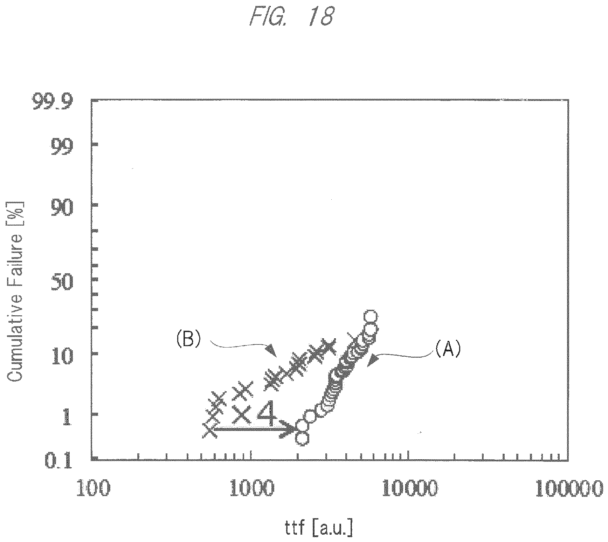

FIG. 18 is a diagram showing an effect of the semiconductor device according to the present embodiment. The horizontal axis represents the time to failure ttf, and the vertical axis represents the cumulative failure. The graph (A) corresponds to the semiconductor device according to the present embodiment, and the graph (B) corresponds to the semiconductor device according to the comparative example. It can be confirmed that the to.1 lifetime (EM (ElectroMigration) lifetime at the cumulative failure of 0.1%) is improved about 4 times in the semiconductor device according to the present embodiment as compared with the comparative example.

### <First Modification>

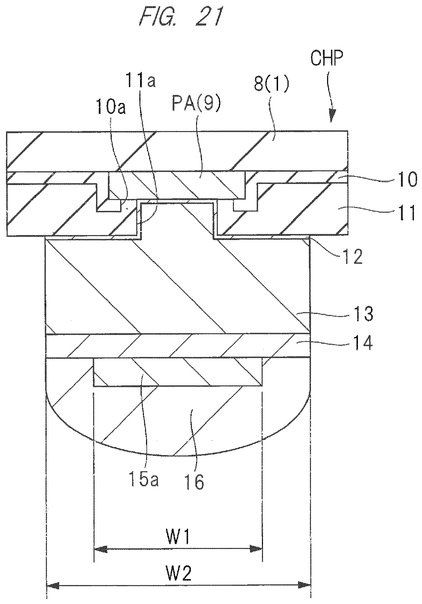

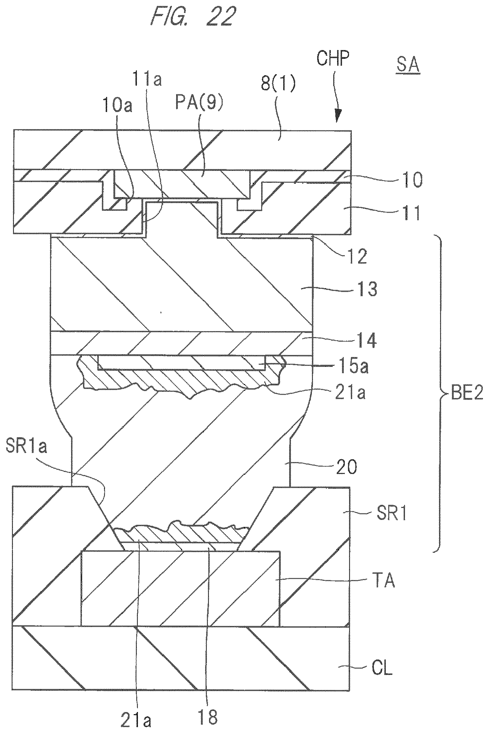

FIG. 21 and FIG. 22 are cross-sectional views of a principal part in a manufacturing process of a semiconductor device according to a first modification. The same characters are given to the configurations common to the present embodiment described above. FIGs. 21 and 22 correspond to FIGs. 6 and 15 of the above-described present embodiment, respectively.

As shown in FIG. 21, a width W1 of a metal film 15a is smaller than a width W2 of the cap film 14. Namely, a side wall of the metal film 15a is covered with the solder layer 16 in the entire circumference. Further, as shown in FIG. 22, an alloy layer 21a is formed at each of the interface between the metal film 15a and the solder layer 20 and the interface between the metal film 18 and the solder layer 20 after the reflow process as in the present embodiment described above.

With this configuration, it is possible to reduce the probability that the solder layer 20 wicks up the side wall of the conductor pillar 13 as shown in FIG. 22. In the case of FIG. 15 of the present embodiment described above, it is assumed that the solder layer 20 wicks up the side wall of the metal film 15, and there is a fear that the solder layer 20 further wicks up the side wall of the conductor pillar 13 beyond the cap film 14. In FIG. 22, ends of the metal film 15a are located on an inner side of ends of the cap film 14, and it is thus possible to reduce the probability that the solder layer 20 wicks up the side wall of the conductor pillar 13.

### <Second Modification>

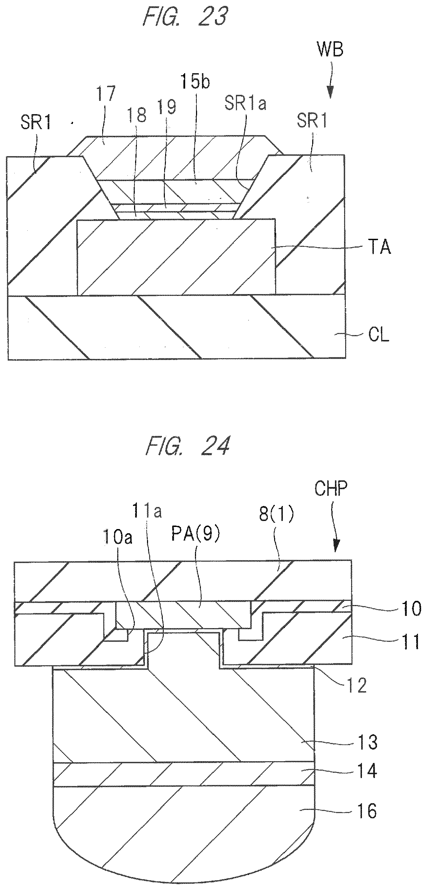

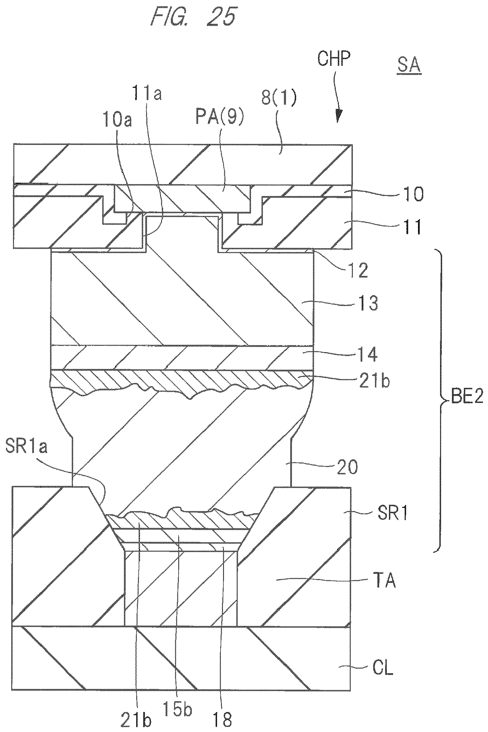

FIGs. 23 to 25 are cross-sectional views of a principal part in a manufacturing process of a semiconductor device according to a second modification. The same characters are given to the configurations common to the present embodiment described above. FIG. 23 corresponds to FIG. 13 of the above-described present embodiment, FIG. 24 corresponds to FIG. 6 of the above-described present embodiment, and FIG. 25 corresponds to FIG. 15 of the above-described present embodiment, respectively.

As shown in FIG. 23, the metal film 18, the barrier layer 19, and a metal film 15b are formed in sequence on the terminal TA of the wiring board WB, and the solder layer 17 is formed on the metal film 15b. Herein, the metal film 15b is made of a copper (Cu) film.

Since the metal film 15b is provided on the side closer to the wiring board WB in the second modification, the metal film made of a copper (Cu) film is not provided between the cap film 14 and the solder layer 16 on the side closer to the semiconductor chip CHP as shown in FIG. 24. The solder layer 16 is in contact with the cap film 14. Then, as shown in FIG. 25, an alloy layer 21b is formed at each of the interface between the cap film 14 and the solder layer 20 and the interface between the metal film 15b and the solder layer 20 after the reflow process as in the present embodiment described above.

Since the alloy layer 21b is formed, it is possible to prevent the diffusion of nickel (Ni) from the metal film 18 to the solder layer 20 during the operation of the semiconductor device SA. Namely, it is possible to prevent the formation of the brittle layer 22 shown in FIG. 19.

In the foregoing, the invention made by the inventor of the present invention has been concretely described based on the embodiment. However, it is needless to say that the present invention is not limited to the foregoing embodiment and various modifications can be made within the scope of the present invention.

## Claims

1. A semiconductor device comprising:
a pad electrode formed over a semiconductor substrate;
a conductor pillar formed on the pad electrode;
a cap film formed on the conductor pillar and made of a nickel film;
a terminal formed in a wiring board;
a first metal film formed on the terminal and made of a nickel film containing phosphorus;
a solder layer interposed between the cap film and the first metal film and containing tin as a main component; and
a first alloy layer interposed between the solder layer and the first metal film and containing tin and copper.

2. The semiconductor device according to claim 1 further comprising:
a second metal film interposed between the cap film and the solder layer and made of a copper film.

3. The semiconductor device according to claim 2 further comprising:
a second alloy layer interposed between the second metal film and the solder layer and containing tin and copper.

4. The semiconductor device according to claim 2 or 3,
wherein a width of the second metal film is smaller than a width of the cap film.

5. The semiconductor device according to one of claims 1 to 4, further comprising:
a third metal film interposed between the first metal film and the first alloy layer and made of a copper film.

6. The semiconductor device according to one of claims 1 to 5,
wherein a film thickness of the conductor pillar is larger than a film thickness of the solder layer.

7. A manufacturing method of a semiconductor device comprising the steps of:
(a) preparing a semiconductor chip including a pad electrode formed over a semiconductor substrate, a conductor pillar formed on the pad electrode, a cap film formed on the conductor pillar and made of a nickel film, a first metal film formed on the cap film and made of a copper film, and a first solder layer formed on the first metal film and containing tin as a main component;
(b) preparing a wiring board including a terminal, a second metal film formed on the terminal and made of a nickel film containing phosphorus, and a second solder layer formed on the second metal film and containing tin as a main component; and
(c) performing heat treatment to the semiconductor chip and the wiring board in a state where the first solder layer and the second solder layer are in contact with each other, thereby melting the first solder layer and the second solder layer to form a third solder layer,
wherein, in the step (c), a first alloy layer containing tin and copper is formed between the second metal film and the third solder layer.

8. The manufacturing method of the semiconductor device according to claim 7,
wherein, in the step (c), a second alloy layer containing tin and copper is formed between the first metal film and the third solder layer.

9. The manufacturing method of the semiconductor device according to claim 7 or 8,
wherein, in the step (a), a width of the first metal film is smaller than a width of the cap film, and
in the step (c), the third solder layer is formed so as to cover a side wall of the first metal film.

10. The manufacturing method of the semiconductor device according to one of claims 7 to 9, further comprising the step of:
(d) injecting a sealing material between the semiconductor chip and the wiring board,
wherein the sealing material covers side walls of the conductor pillar, the cap film, the first metal film, and the third solder layer.

11. The manufacturing method of the semiconductor device according to one of claims 7 to 10, further comprising the step of:
(e) connecting a solder ball to a land formed on a surface opposite to the terminal of the wiring board.

12. A manufacturing method of a semiconductor device comprising the steps of:
(a) preparing a semiconductor chip including a pad electrode formed over a semiconductor substrate, a conductor pillar formed on the pad electrode, a cap film formed on the conductor pillar and made of a nickel film, and a first solder layer formed on the cap film and containing tin as a main component;
(b) preparing a wiring board including a terminal, a first metal film formed on the terminal and made of a nickel film containing phosphorus, a second metal film formed on the first metal film and made of a copper film, and a second solder layer formed on the second metal film and containing tin as a main component; and
(c) performing heat treatment to the semiconductor chip and the wiring board in a state where the first solder layer and the second solder layer are in contact with each other, thereby melting the first solder layer and the second solder layer to form a third solder layer,
wherein, in the step (c), a first alloy layer containing tin and copper is formed between the second metal film and the third solder layer.

13. The manufacturing method of the semiconductor device according to claim 12,
wherein, in the step (c), a second alloy layer containing tin and copper is formed between the cap film and the third solder layer.
